# EUROPÄISCHE PATENTANMELDUNG

(11) **EP 3 246 935 A1**
(43) Veröffentlichungstag der Anmeldung: **22.11.2017**
(21) Anmeldenummer: 16170628.8
(22) Anmeldetag: 20.05.2016
(51) Int. Cl.: H01J 37/32

(54) **PLASMABEHANDLUNGSVORRICHTUNG MIT EINER KONTAKTLOSEN HF-SPANNUNGSZUFÜHRUNG AN EINE BEWEGLICHE PLASMAELEKTRODENEINHEIT UND VERFAHREN ZUM BETREIBEN EINER SOLCHEN PLASMABEHANDLUNGSVORRICHTUNG**

(71) Anmelder: Meyer Burger (Germany) AG, 09337 Hohenstein-Ernstthal (DE)
(72) Erfinder: Schlemm, Dr. Hermann, 07751 Milda (DE); Kehr, Dr. Mirko, 09439 Amtsberg (DE); Scheit, Dr. Uwe, 015230 Frankfurt (Oder) (DE); Ansorge, Dr. Erik, 09127 Chemnitz (DE); Decker, Daniel, 09427 Ehrenfriedersdorf (DE)
(74) Vertreter: Kailuweit & Uhlemann Patentanwälte Partnerschaft mbB

(57) **Zusammenfassung**

Die Erfindung betrifft eine Plasmabehandlungsvorrichtung, bei der eine Plasmaelektrodeneinheit in eine Prozesskammer ein- und aus ihr ausgefahren werden kann und bei der eine, von einem Generator bereitgestellte Hochfrequenzleistung mit Hilfe eines oder mehrerer elektromagnetischer Felder und ohne einen ohmschen elektrischen Kontakt an die Plasmaelektrodeneinheit übertragen wird. Dazu weist die Plasmabehandlungsvorrichtung eine Übertragungseinrichtung auf, die einen primären Koppelteil enthält, der innerhalb der Prozesskammer angeordnet ist und ein elektromagnetisches Feld erzeugen kann. Die Plasmaelektrodeneinheit enthält einen sekundären Koppelteil, der fest mit der Plasmaelektrodeneinheit verbunden ist und geeignet ist, das elektromagnetische Feld zu empfangen und in eine elektrische Wechselleistung umzuwandeln. Darüber hinaus wird ein Verfahren zum Betreiben einer solchen Plasmabehandlungsvorrichtung bereitgestellt.

## Beschreibung

Die Erfindung betrifft eine Plasmabehandlungsvorrichtung mit einer kontaktlosen Zuführung einer hochfrequenten Spannung an eine bewegliche Plasmaelektrodeneinheit, die zum Erzeugen eines kapazitiv gekoppelten Plasmas, insbesondere im Vakuum, geeignet ist. Darüber hinaus betrifft die Erfindung ein Verfahren zum Betreiben einer solchen Plasmabehandlungsvorrichtung.

Plasmaprozesse werden beispielsweise in der Solarzellenherstellung, der Mikroelektronik oder der Veredlung von Substratoberflächen (z. B. Glas) zur Abscheidung oder Entfernung von Schichten oder Partikeln, zur Dotierung von Schichten, zum Beispiel durch Plasmaimmersionslonenimplantation, oder zum Reinigen oder Aktivieren der Oberfläche eines Substrates genutzt.

Bei kapazitiv gekoppelten Plasmen befindet sich das zu behandelnde Substrat in einem Raum zwischen zwei Plasmaelektroden, wobei mindestens einer dieser Plasmaelektroden eine hochfrequente Spannung zugeführt wird. Dabei kann das Substrat über einen direkten Kontakt mit einer der Plasmaelektroden mit einer Spannung beaufschlagt werden. Dies eignet sich insbesondere für Plasmabehandlungsvorrichtungen, bei denen das Substrat oder die Substrate ortsfest auf einer der Plasmaelektroden in einer Prozesskammer angeordnet sind. Für Anlagen, in denen die Substrate sich durch eine Plasmaprozesszone hindurchbewegen, so genannte Inline-Anlagen, ist die kapazitive Zuführung einer Spannung zu einem Substrat bekannt wobei jedoch die Plasmaelektroden selbst fest angeordnet und über feste Kontakte mit einer Spannungsversorgung verbunden sind. Solche Anlagen sind bspw. in der DE 43 01 189 A1 und der DE 10 2010 060 762 A1 beschrieben.

Um den Durchsatz von Substraten bei der Plasmaprozessierung zu erhöhen, werden batch-Systeme, in denen mehrere Substrate gleichzeitig behandelt werden, verwendet. Dabei können die Substrate mit der zu prozessierenden Oberfläche neben- oder übereinander angeordnet sein. Dabei sind die Substrate jeweils zwischen den Elektroden eines Plasmaelektrodenpaares angeordnet, die elektrisch voneinander isoliert und so mit einer Spannungszuführung verbunden sind, dass zwischen jedem dieser Plasmaelektrodenpaare kapazitiv ein Plasma erzeugt werden kann. Bei übereinander angeordneten Substraten werden in einer Plasmaelektrodeneinheit bis zu 200 Elektroden, die jeweils in einem typischen Abstand von 3 bis 30 mm parallel zueinander angeordnet sind, abwechselnd mit einer von mindestens zwei Spannungszuführungen verbunden, von denen mindestens eine mit einem Hochfrequenzgenerator einer Spannungsversorgung, die außerhalb der Plasmabehandlungsanlage installiert ist, verbunden ist. Eine der mindestens zwei Spannungszuführungen kann auch auf Masse liegen.

Aus der DE 198 08 206 A1 ist eine Plasmabehandlungsvorrichtung bekannt, bei der die Plasmaelektrodeneinheit innerhalb der Prozesskammer verbleibt und die Plasmaelektrodeneinheit und der Substratträger erst nach Einbringen des Substratträgers in die Plasmabehandlungskammer so zueinander positioniert werden, dass jeweils ein Substrat zwischen den Elektroden eines Plasmaelektrodenpaares angeordnet ist. Damit kann die Spannungszuführung an die Plasmaelektrodeneinheit bspw. mit einer fest installierten koaxialen Durchführung durch die Wand der Plasmabehandlungskammer realisiert werden.

Ein anderes batch-System, bei dem die Plasmaelektrodeneinheit im Substratträger (Plasmaboat) angeordnet ist und mit diesem in bzw. aus der Prozesskammer ein- bzw. ausgefahren wird, ist beispielsweise in der DE 10 2008 019 023 A1 beschrieben. Sobald der Substratträger mit den in der Plasmaelektrodeneinheit platzierten Substraten in eine Plasmabehandlungsanlage eingebracht wurde, wird eine elektrische Verbindung zwischen den zwei Spannungszuführungen der Plasmaelektrodeneinheit und dem Hochfrequenzgenerator hergestellt.

Die Herstellung der elektrischen Verbindung wird bei dem Substratträger der DE 10 2008 019 023 A1 mit Hilfe von Stecker-Buchsen-Verbindungen realisiert, wobei die Stecker mittels einer Zustellvorrichtung von unten in die am Substratträger befindlichen Buchsen eingeführt werden, sobald sich der Substratträger an der vorgesehenen Position in der Plasmabehandlungsanlage befindet. Für die Herstellung des ohmschen elektrischen Kontakts werden typische Kontaktwerkstoffe eingesetzt, soweit sie in der Prozessumgebung des Plasmaprozesses, insbesondere auch bei Temperaturen zwischen 200 bis 500°C, einsetzbar sind. Z.B. haben sich Kontaktpaarungen aus Graphit bewährt.

Solche und andere mechanische Kontakte, bei denen eine direkte mechanische Verbindung und ein ohmscher elektrischer Kontakt zwischen einer, an einem beweglichen Substratträger befindlichen Kontaktstelle und einer in der Prozesskammer installierten Kontaktstelle erzeugt wird, weisen eine typische Schaltlebensdauer im Bereich von 10⁴ Schaltzyklen auf und müssen daher bei kurzen Behandlungszeiten der Substrate innerhalb der Prozesskammer sehr häufig, bspw. bereits nach 3 Wochen, gewartet oder erneuert werden. Bei der Übertragung von hochfrequenten Spannungen bzw. Strömen (bspw. 13,56 MHz) ist die Belastung der mechanischen Schaltkontakte nochmals größer, so dass die Standzeiten sogar noch geringer ausfallen. Darüber hinaus ist die technische Realisierung von mechanischen Kontakten zur Übertragung von hochfrequenten Spannungen aufwendiger als für niederfrequente Spannungen.

Es ist daher Aufgabe der Erfindung, eine Plasmabehandlungsvorrichtung bereitzustellen, bei der eine Plasmaelektrodeneinheit in die Plasmabehandlungsvorrichtung ein- und ausgefahren werden kann und bei der eine hochfrequente Spannung der Plasmaelektrodeneinheit derart zugeführt wird, dass die Nachteile des Standes der Technik vermieden oder verringert werden.

Die Aufgabe wird gelöst durch eine Plasmabehandlungsvorrichtung gemäß Anspruch 1 und durch ein Verfahren zum Betreiben einer solchen Plasmabehandlungsvorrichtung gemäß Anspruch 14. Bevorzugte Ausführungsformen finden sich in den Unteransprüchen.

Die erfindungsgemäße Plasmabehandlungsvorrichtung weist eine Prozesskammer, eine Plasmaelektrodeneinheit und eine Übertragungseinrichtung auf. Die Plasmaelektrodeneinheit besteht aus mindestens einem Plasmaelektrodenpaar aus einer ersten Plasmaelektrode und einer zweiten Plasmaelektrode, die parallel, einander gegenüber liegend und elektrisch voneinander isoliert angeordnet sind. Unter einer Plasmaelektrodeneinheit wird dabei jede Anordnung von Plasmaelektrodenpaaren verstanden, bei denen jeweils alle ersten Plasmaelektroden der Plasmaelektrodenpaare über einen ohmschen Kontakt elektrisch leitend miteinander verbunden sind und jeweils alle zweiten Plasmaelektroden der Plasmaelektrodenpaare über einen ohmschen Kontakt elektrisch leitend miteinander verbunden sind. Die Plasmaelektrodeneinheit ist geeignet, in die Prozesskammer ein- und aus ihr ausgefahren zu werden, wobei die Plasmaelektrodeneinheit vorzugsweise im Ganzen ein- bzw. ausgefahren und bewegt wird. Die Plasmaelektrodeneinheit kann dabei bspw. ein Teil eines Substratträgers sein, so dass ein oder mehrere Substrate, von denen jedes zwischen den Plasmaelektroden eines Plasmaelektrodenpaares angeordnet ist, mittels eines Plasmas, das in der Prozesskammer zwischen den Plasmaelektroden des Plasmaelektrodenpaares erzeugt und aufrechterhalten wird, behandelt werden kann. Unter Behandlung wird dabei das Aufbringen oder Erzeugen von Schichten auf die bzw. an einer Oberfläche des Substrates, das Entfernen einer Schicht oder von Partikeln von einer Oberfläche des Substrates, das Dotieren von Schichten oder das Reinigen oder Aktivieren einer Oberfläche des Substrates verstanden. Um das Plasma zu erzeugen und/oder aufrechtzuerhalten, wird den Plasmaelektroden der Plasmaelektrodeneinheit durch die Übertragungseinrichtung die notwendige elektrische Leistung von einem Generator, insbesondere einem Hochfrequenzgenerator, der außerhalb der Plasmabehandlungsvorrichtung angeordnet ist, bereitgestellt, wenn sich die Plasmaelektrodeneinheit in der Prozesskammer in einer Behandlungsposition befindet. Die Übertragungseinrichtung ist dabei zumindest teilweise in der Prozesskammer angeordnet. Einige Teile der Übertragungseinheit, wie beispielsweise Einrichtungen zum Anpassen einer Hochfrequenzleistung an die in der Plasmabehandlungsvorrichtung vorliegenden Bedingungen, z.B. Druck, Temperatur und Gaszusammensetzung, welche üblicherweise als Matchbox bezeichnet werden, befinden sich vorzugsweise außerhalb der Prozesskammer.

Die erfindungsgemäße Plasmabehandlungsvorrichtung ist dadurch gekennzeichnet, dass die Übertragungseinrichtung einen primären Koppelteil enthält, der innerhalb der Prozesskammer angeordnet ist, und die Plasmaelektrodeneinheit einen sekundären Koppelteil enthält, der fest mit der Plasmaelektrodeneinheit verbunden ist. Dabei sind der primäre Koppelteil und der sekundäre Koppelteil jeweils so angeordnet, dass sie geeignet sind, eine vom Generator bereitgestellte Hochfrequenzleistung mit Hilfe elektromagnetischer Felder und ohne einen ohmschen elektrischen Kontakt an die Plasmaelektrodeneinheit, vorzugsweise an jede Plasmaelektrode der Plasmaelektrodeneinheit, zu übertragen. Mit anderen Worten, die Hochfrequenzleistung wird von der Übertragungseinrichtung kontaktlos an die Plasmaelektrodeneinheit übertragen, wobei unter "kontaktlos" "ohne direkten, ohmschen elektrischen Kontakt" verstanden wird.

Damit entfällt die im Stand der Technik notwendige mindestens eine ohmsche Kontaktstelle zwischen der Übertragungseinrichtung und der Plasmaelektrodeneinheit, wodurch der Verschleiß des Kontaktes durch mechanische Abnutzung oder Bildung von Lichtbögen etc. weitgehend vermieden wird. Mit der erfindungsgemäßen kontaktlosen Hochfrequenzleistungsübertragung mit Hilfe von elektromagnetischen Feldern kann durch den möglichen physischen Abstand zwischen dem primären Koppelteil und dem sekundären Koppelteil eine nahezu verschleißfreie Leistungsübertragung erreicht werden, wodurch längere Standzeiten der Plasmabehandlungsvorrichtung und damit niedrigere Wartungskosten erzielt werden können.

Die Vorteile der erfindungsgemäßen kontaktlosen Übertragung kommen insbesondere bei der Übertragung hochfrequenter Leistungen im Bereich von 10 kHz bis 100 MHz, vorzugsweise für Frequenzen größer als 1 MHz, zum Tragen. Leistungen mit solch hohen Frequenzen sind mit ohmschen Kontakten schlecht übertragbar. Dadurch können in der erfindungsgemäßen Plasmabehandlungsvorrichtung auch Plasmaprozesse durchgeführt werden, die eine hohe Anregungsfrequenz für die Erzeugung und Aufrechterhaltung des Plasmas benötigen, wie bspw. die Abscheidung von amorphem Silizium.

Der primäre Koppelteil und der sekundäre Koppelteil enthalten induktive oder kapazitive Elemente zum Erzeugen eines elektromagnetischen Feldes bzw. zum Umwandeln dieses Feldes in eine elektrische Wechselleistung. Diese induktiven und kapazitiven Elemente können in die Matchbox der Übertragungseinrichtung bzw. in den Stromkreis der Plasmaelektrodeneinheit so integriert werden, dass an ihnen nur ein Minimum an Wirkleistung abfällt und damit ein Maximum an Wirkleistung für die Erzeugung und Aufrechterhaltung eines Plasmas zwischen den Plasmaelektroden eines Plasmaelektrodenpaares der Plasmaelektrodeneinheit zur Verfügung steht.

Vorzugsweise sind die Plasmaelektroden der Plasmaelektrodeneinheit so ausgebildet, dass sie gegen Massepotential isoliert in der Plasmabehandlungsvorrichtung angeordnetsind, wenn sich die Plasmaelektrodeneinheit in einer Behandlungsposition befindet. Weiterhin sind der primäre Koppelteil und der sekundäre Koppelteil so ausgebildet, dass sie geeignet sind, die Hochfrequenzleistung einander zugeordneten Plasmaelektroden der Plasmaelektrodeneinheit, d.h. den Plasmaelektroden eines spezifischen Plasmaelektrodenpaares, symmetrisch bezüglich Massepotential zuzuführen. Damit werden in die verschiedenen Plasmaelektroden des spezifischen Plasmaelektrodenpaares um 180° versetzte Hochfrequenzspannungen eingespeist. Dadurch liegt zwischen den Plasmaelektroden das Doppelte der jeweils eingespeisten Hochfrequenzspannung an, so dass der Betrag der jeweils eingespeisten Hochfrequenzspannung gegenüber der zur Erzeugung und Aufrechterhaltung des Plasmas notwendigen Spannung verringert, insbesondere etwa halbiert, werden kann. Damit liegen an den Elementen des primären und des sekundären Koppelteils, den einzelnen Plasmaelektroden sowie den Zuleitungen zwischen dem sekundären Koppelteil und den Plasmaelektroden nur vergleichsweise niedrige hochfrequente Spannungen gegenüber Masse an, wodurch parasitäre Plasmen auch ohne die Anordnung von isolierenden oder leitfähigen Abschirmungen weitgehend unterdrückt werden. Damit kann der Aufbau der Plasmaelektrodeneinheit sowie der Übertragungseinrichtung bzw. der gesamten Plasmabehandlungsvorrichtung vereinfacht werden, was zur Einsparung von Kosten führt.

Bei der Verwendung von induktiven Elementen im primären und sekundären Koppelteil, können auch Hochfrequenzgeneratoren und mit diesen verbundenen Elemente, die für eine Erzeugung einer asymmetrischen Hochfrequenzspannung geeignet sind, genutzt werden, da die induktiven Elemente symmetrische Spannungen im sekundären Koppelteil aus einer am primären Koppelteil bereitgestellten asymmetrischen Spannung erzeugen. Dies bietet Kostenvorteile gegenüber der Nutzung von Generatoren und mit diesen verbundenen Elementen, die für die Erzeugung einer symmetrischen Hochfrequenzspannung notwendig wären.

Vorzugsweise umfasst die Plasmabehandlungsvorrichtung weiterhin eine Zustelleinheit, die geeignet ist, den primären Koppelteil in eine Richtung zum sekundären Koppelteil hin oder von diesem weg zu bewegen, wenn sich die Plasmaelektrodeneinheit in der Plasmabehandlungsvorrichtung in einer Behandlungsposition befindet. Damit kann der Abstand zwischen dem primären Koppelteil und dem sekundären Koppelteil jeweils so eingestellt werden, dass für die Bewegung der Plasmaelektrodeneinheit ein großer Abstand eingestellt und eine Beschädigung der Koppelteile während der Bewegung der Plasmaelektrodeneinheit vermieden wird, während der Abstand in der Behandlungsposition entsprechend der für die Übertragung der Hochfrequenzleistung notwendigen Bedingungen verringert ist. Bei Nutzung von induktiven Elementen in den Koppelteilen, d.h. einer Primärspule im primären Koppelteil und einer Sekundärspule im sekundären Koppelteil, liegt der Abstand in der Behandlungsposition zwischen 3% und 10% des Durchmessers der Spulen bei Flachspulen und zwischen 50% und 100% des Durchmesser der Spulen bei Ring- oder Zylinderspulen. Bei Nutzung von kapazitiven Elementen in den Koppelteilen kann in der Behandlungsposition ein Abstand von 0 (Null) zwischen dem primären und dem sekundären Koppelteil oder auch ein größerer Abstand im Bereich von 0,1 bis 10 mm eingestellt werden. Dabei kann die Zustelleinheit den primären Koppelteil bspw. um eine Strecke von 5 bis 20 mm bewegen, vorzugsweise mehr als 10 mm. Die Zustelleinheit kann dabei mit bekannten Mitteln, bspw. mit mechanischen, pneumatischen, hydraulischen oder elektromagnetischen Antriebselementen, versehen sein.

In einer ersten Ausführungsform weisen der primäre Koppelteil mindestens eine Primärspule und der sekundäre Koppelteil mindestens eine Sekundärspule auf, wobei jede Sekundärspule einer Primärspule zugeordnet ist. Jeweils ein Ende der Sekundärspule ist elektrisch leitend mit einer ersten Plasmaelektrode eines Plasmaelektrodenpaares verbunden, während ein anderes Ende der Sekundärspule mit einer zweiten Plasmaelektrode des selben Plasmaelektrodenpaares elektrisch leitend verbunden ist. Die mindestens eine Primärspule ist geeignet, mit Hilfe der vom Hochfrequenzgenerator bereitgestellten Hochfrequenzleistung ein elektromagnetisches Feld zu erzeugen, während die mindestens eine Sekundärspule geeignet ist, das von der mindestens einen Primärspule erzeugte elektromagnetische Feld aufzunehmen und eine Hochfrequenzleistung zu erzeugen, die mit der an der Primärspule bereitgestellten Wechselleistung korrespondiert. Die Spulen weisen dabei eine Windungszahl zwischen 1 und 50, vorzugsweise zwischen 3 und 20 auf, wobei die Anzahl der optimal einsetzbaren Windungen aus hochfrequenztechnischen Gründen mit der Frequenz abnimmt. Daher sind typische induktive Koppelteile insbesondere zur Übertragung von Hochfrequenzleistungen mit einer Frequenz kleiner als 20 MHz, insbesondere kleiner als 10 MHz geeignet.

Vorzugsweise sind mindestens eine der mindestens einen Primärspule und die dieser Primärspule zugeordnete mindestens eine Sekundärspule als Flachspulen ausgebildet. Flachspulen sind Spulen, bei denen ein Leiter in Form einer Spirale oder eines Mäanders ausgebildet ist, wobei sich alle Leiterabschnitte (Windungen) in einer Ebene befinden. Die Ebenen der Primärspule und der mindestens einen Sekundärspule sind parallel zueinander angeordnet, wobei die Mittelpunkte der Primärspule und der mindestens einen Sekundärspule auf einer Achse liegen. Die Layouts der Primärspule und der mindestens einen Sekundärspule können gleich oder verschieden voneinander sein. Der Durchmesser der Spulen bzw. deren Seitenmaß (Kantenlänge) bei einem viereckigen Layout liegt typischerweise im Bereich von 50 bis 250 mm. Die Spulen können aus einem Rohrmaterial oder einem Flachmaterial bestehen. Als Rohrmaterial, insbesondere für die Primärspule, kann beispielsweise ein Kupferrohr mit einem Durchmesser im Bereich von 4 bis 12 mm und einer Materialdicke von 1 bis 2 mm verwendet werden, welches vorzugsweise eine Silberschicht an der Oberfläche aufweist. Als Flachmaterial, insbesondere für die Primärspule, kann beispielsweise ein Bandmaterial mit einer Dicke von 0,25 bis 2 mm und einer Breite von 5 bis 50 mm aus Kupfer oder Aluminium verwendet werden, welches vorteilhafterweise ebenfalls eine Silberschicht an der Oberfläche aufweist.

Alternativ sind mindestens eine der mindestens einen Primärspule und die dieser Primärspule zugeordnete mindestens eine Sekundärspule als Zylinderspulen ausgebildet, bei denen die Windungen der Spule übereinander und nicht auf einer Ebene liegen. Zylinderspulen werden typischerweise aus Rohrmaterial, wie bereits mit Bezug auf die Flachspulen beschrieben, hergestellt. Der Durchmesser der Spulen liegt vorzugsweise im Bereich von 30 bis 200 mm, wobei die Primärspule und die mindestens eine Sekundärspule vorteilhafterweise denselben Durchmesser aufweisen. Die Primärspule und die mindestens eine Sekundärspule können die gleiche oder unterschiedliche Windungszahlen aufweisen. Die Primärspule und die mindestens eine Sekundärspule haben dabei die gleiche Mittelachse.

Die Primärspule kann in beiden Ausführungsformen mit einfachen Mitteln gekühlt werden, bspw. mittels einer Fluidkühlung, z.B. mit Wasser, im Inneren der Spule bei Verwendung eines Rohrmaterials. Dies wird insbesondere bei der Übertragung von Hochfrequenzleistungen größer 1 kW erforderlich. Demgegenüber ist die Kühlung der Sekundärspule nur schwer zu realisieren, so dass die mindestens eine Sekundärspule aus einem hochfrequenztechnisch geeigneten und temperaturstabilen Werkstoff besteht. Für Temperaturbereiche bis 250°C sind versilberte Kupfer- oder Edelstahlspulen einsetzbar, während für Temperaturen bis 500°C Spulen aus hochleitfähigem und poliertem, dünnen Graphit, vorzugsweise ebenfalls mit einer Silberbeschichtung, eingesetzt werden. Bei hohen Frequenzen fließt der Hochfrequenzstrom hauptsächlich auf der Oberfläche des Spulenmaterials (Skin-Effekt), so dass sogar Spulen aus isolierendem Material mit einer dünnen, elektrisch leitfähigen Beschichtung der Oberfläche, bspw. mit Graphit, Silber, Aluminium oder Kupfer, eingesetzt werden können.

In einer zweiten Ausführungsform weisen der primäre Koppelteil mindestens zwei Primärelektroden und der sekundäre Koppelteil mindestens zwei Sekundärelektroden aufweisen, wobei jede Sekundärelektrode einer spezifischen Primärelektrode zugeordnet und geeignet ist, mit dieser einen Kondensator auszubilden. Die Primärelektrode eines ersten Kondensators ist elektrisch leitend mit einem Anschluss des Hochfrequenzgenerators verbunden, während die Primärelektrode eines zweiten Kondensators mit dem anderen Anschluss des Hochfrequenzgenerators elektrisch leitend verbunden ist. Die Sekundärelektrode des ersten Kondensators ist elektrisch leitend mit einer ersten Plasmaelektrode eines spezifischen Plasmaelektrodenpaares verbunden, während die Sekundärelektrode des zweiten Kondensators mit einer zweiten Plasmaelektrode des spezifischen Plasmaelektrodenpaares elektrisch leitend verbunden ist. Es können auch mehrere Sekundärelektroden, die sich bspw. in der Fläche oder dem Material des Dielektrikums unterscheiden, einer Primärelektrode zugeordnet sein. Damit können die mehreren Sekundärelektroden unterschiedliche elektrische Leistungen aufnehmen und diese jeweils unterschiedlichen Bereichen der Plasmaelektrodeneinheit zuführen.

Damit bilden die Primärelektroden des primären Koppelteils und die Sekundärelektroden des sekundären Koppelteils mindestens zwei auftrennbare Kondensatoren aus, die geeignet sind, den Plasmaelektroden der Plasmaelektrodeneinheit eine symmetrische Hochfrequenzspannung bereitzustellen. Typische Kapazitäten der Koppelkondensatoren liegen im Bereich zwischen 0,5 und 2 nF. Da an den Koppelkondensatoren deutlich weniger Spannung abfallen soll, als die Brennspannung des Plasmas beträgt, weisen die Koppelkondensatoren jeweils eine Kapazität größer oder gleich einer Minimalkapazität auf, die von den Anforderungen der Plasmabehandlungsvorrichtung abhängt. So ist die Minimalkapazität für eine Wechselleistung mit einer Frequenz von 13,56 MHz bspw. 1 nF. Da der Spannungsabfall an Kondensatoren mit steigender Frequenz abnimmt, sind kapazitive Koppelteile insbesondere zur Übertragung von Hochfrequenzleistungen mit einer Frequenz im Bereich von 10 bis 100 MHz, insbesondere für Frequenzen größer als 20 MHz geeignet.

Zwischen der Primärelektrode und der Sekundärelektrode eines Koppelkondensators kann ein beliebiges Dielektrikum vorliegen, bspw. die in der Prozesskammer vorhandene Atmosphäre. In diesem Fall sind die Primärelektrode und die Sekundärelektrode während der Übertragung der Wechselleistung voneinander beabstandet angeordnet. Jedoch weist vorzugsweise mindestens eine der Primärelektrode oder der Sekundärelektrode eines spezifischen Kondensators ein zusätzliches Dielektrikum auf. Das heißt: Entweder auf der Primärelektrode oder auf der Sekundärelektrode oder auf der Primärelektrode und der Sekundärelektrode ist ein zusätzliches Dielektrikum angeordnet. Das Dielektrikum hat vorzugsweise eine Dicke von 0,25 bis 1 mm und besteht aus einem Material mit einer relativen Dielektrizitätskonstante von größer 5. Dies kann bspw. Aluminiumoxid mit einer relativen Dielektrizitätskonstanten von 8 bis 9 sein. Vorzugsweise wird der primäre Koppelteil durch die Zustelleinheit in Richtung des sekundären Koppelteils bewegt, wenn sich die Plasmaelektrodeneinheit in der Prozesskammer in einer Behandlungsposition befindet, so dass dann das Dielektrikum mit der jeweils zugeordneten Sekundärelektrode oder Primärelektrode des spezifischen Kondensators in mechanischem Kontakt steht. Nach Beendigung des Plasmabehandlungsprozesses wird der primäre Koppelteil wieder von dem sekundären Koppelteil entfernt und die Koppelkondensatoren damit aufgetrennt, so dass die Plasmaelektrodeneinheit wieder aus der Plasmabehandlungsvorrichtung ausgefahren werden kann.

Besonders bevorzugt weisen die Primärelektrode und die Sekundärelektrode mindestens eines spezifischen Kondensators jeweils eine nichtplanare Oberfläche auf, die der jeweils anderen Elektrode gegenüberliegt und mit der Form der nichtplanaren Oberfläche der jeweils anderen Elektrode korrespondiert. Dabei soll die Form der Oberflächen so ausgestaltet sein, dass die Primärelektrode und die Sekundärelektrode ohne einen parasitären Spalt ineinander greifen, wenn die Primärelektrode und die Sekundärelektrode miteinander in Kontakt gebracht werden. Darüber hinaus muss die Form geeignet sein, die Primärelektrode und die Sekundärelektrode leicht und ohne Beschädigung der Elektroden wieder voneinander zu lösen. Vorteilhafterweise ist die Form der Oberflächen dabei so gewählt, dass eine Selbstjustage der Primärelektrode und der Sekundärelektrode zueinander erfolgt, wenn die Primärelektrode und die Sekundärelektrode miteinander in Kontakt gebracht werden.

Die bisher beschriebenen Ausführungsformen des primären und des sekundären Koppelteils sind in besonderer Weise für die Übertragung einer Hochfrequenzleistung zu einer Plasmaelektrodeneinheit, die während der Leistungsübertragung stationär bzw. unbeweglich in der Prozesskammer angeordnet ist, geeignet. Dazu weist der primäre Koppelteil oder der sekundäre Koppelteil vorzugsweise eine Justagevorrichtung auf, mit der die induktiven oder kapazitiven Elemente des primären Koppelteils und des sekundären Koppelteils entlang einer Richtung senkrecht zum Abstand zwischen dem primären Koppelteil und dem sekundären Koppelteil in der Behandlungsposition so zueinander positioniert werden können, dass die Übertragung der Hochfrequenzleistung in einem gewünschten, vorbestimmten Maß gewährleistet wird.

In einer weiteren Ausführungsform der kapazitiven Leistungsübertragung weisen die Primärelektrode und die Sekundärelektrode mindestens eines spezifischen Kondensators jeweils mindestens zwei plattenförmige Bereiche auf, die sich von einem gemeinsamen Anschlussbereich aus jeweils in Richtung der jeweils anderen Elektrode sowie in eine Richtung erstrecken, entlang der die Plasmaelektrodeneinheit in die Plasmabehandlungsvorrichtung ein- und aus ihr ausgefahren wird. Die Anzahl der plattenförmigen Bereiche der Primärelektrode und der Sekundärelektrode eines spezifischen Kondensators können gleich oder um eins verschieden sein. Die Primärelektrode und die Sekundärelektrode sind jeweils kammartig ausgebildet, wobei die plattenförmigen Bereiche die Zinken des jeweiligen Elektrodenkammes bilden und in die Lücken zwischen den Zinken des anderen Elektrodenkamms hineinreichen. Dabei sind die plattenförmigen Bereiche der Primärelektrode und der Sekundärelektrode zumindest teilweise einander gegenüber angeordnet, wenn sich die Plasmaelektrodeneinheit in der Plasmabehandlungsvorrichtung in einer Behandlungsposition befindet. Das heißt, die plattenförmigen Bereiche der Primärelektrode und der Sekundärelektrode befinden sich einander gegenüber in einer Richtung, die senkrecht zur Ausdehnungsebene der plattenförmigen Bereiche verläuft. In dieser Richtung sind die plattenförmigen Bereiche voneinander mit einem Abstand im Bereich von 0,1 bis 10 mm beabstandet, wobei sich zwischen den Bereichen die in der Prozesskammer vorhandene Atmosphäre befindet. Der Abstand soll dabei ein Optimum zwischen einer großen Koppelkapazität, verbunden mit einem kleinen Abstand, und der Verhinderung eines parasitären Plasmas zwischen den Elektroden, verbunden mit einem großen Abstand, aufweisen. Mit dieser Ausgestaltung der Primär- und Sekundärelektrode ist die kapazitive Kopplung zur Übertragung der Hochfrequenzleistung besonders günstig ohne die Nutzung einer Zustelleinheit und ohne eine besonders genaue Positionierung des sekundären Koppelteils der Plasmaelektrodeneinheit bezüglich dem primären Koppelteil der Übertragungseinrichtung realisierbar. In einer besonderen Ausführungsform ist sogar die Bewegung der Plasmaelektrodeneinheit während der Übertragung der Hochfrequenzleistung möglich, so dass die Leistungsübertragung auch für Plasmabehandlungsvorrichtungen, in denen die Plasmaelektrodeneinheit kontinuierlich bewegt wird, sogenannte Durchlaufanlagen, geeignet ist.

Die induktiven oder kapazitiven Elemente sowohl im primären Koppelteil, als auch im sekundären Koppelteil, d.h. die Spulen oder Kondensatorelektroden, können in allen Ausführungsformen mittels isolierender oder leitfähiger Elemente abgeschirmt sein, um die Ausbildung parasitärer Plasmen zu verhindern.

Entsprechend einer besonderen Ausführungsform enthält die Plasmabehandlungsvorrichtung mehrere Plasmaelektrodeneinheiten und mehrere Übertragungseinrichtungen. Dabei ist jede Plasmaelektrodeneinheit einer spezifischen Übertragungseinrichtung zugeordnet und jede Übertragungseinrichtung weist einen primären Koppelteil und jede Plasmaelektrodeneinheit einen sekundären Koppelteil auf, die zur Übertragung von elektrischer Hochfrequenzleistung an die jeweilige Plasmaelektrodeneinheit mittels elektromagnetischer Felder und ohne ohmschen elektrischen Kontakt zueinander geeignet sind. Mit anderen Worten: Die primären und sekundären Koppelteile sind wie oben beschrieben ausgestaltet.

Das erfindungsgemäße Verfahren zum Betreiben der erfindungsgemäßen Plasmabehandlungsvorrichtung umfasst die Schritte zum Einfahren der Plasmaelektrodeneinheit in die Prozesskammer, zum Erzeugen eines elektromagnetischen Feldes im primären Koppelteil und Übertragen der elektrischen Hochfrequenzleistung an den sekundären Koppelteil, zum Trennen des primären Koppelteils von der von dem Hochfrequenzgenerator bereitgestellten elektrischen Hochfrequenzleistung und zum Ausfahren der Plasmaelektrodeneinheit aus der Prozesskammer. Das Verfahren beginnt dabei mit dem Einfahren der Plasmaelektrodeneinheit in die Prozesskammer entlang einer ersten Richtung, bis sich die Plasmaelektrodeneinheit in einer Behandlungsposition in der Prozesskammer befindet und sich der primäre Koppelteil und der sekundäre Koppelteil zumindest teilweise gegenüber liegen. Nach dem Einfahren der Plasmaelektrodeneinheit wird durch Anlegen einer von einem Generator bereitgestellten elektrischen Hochfrequenzleistung an den primären Koppelteil im primären Koppelteil ein elektromagnetisches Feld erzeugt. Dieses elektromagnetische Feld überträgt die elektrische Hochfrequenzleistung an den sekundären Koppelteil, wodurch ein Plasma zwischen den Plasmaelektroden eines Plasmaelektrodenpaares der Plasmaelektrodeneinheit erzeugt und aufrechterhalten wird. Nach Erreichen eines Bearbeitungszieles in der Prozesskammer wird der primäre Koppelteil von der von dem Generator bereitgestellten elektrischen Hochfrequenzleistung getrennt und danach die Plasmaelektrodeneinheit aus der Prozesskammer entlang der ersten Richtung ausgefahren.

Das erfindungsgemäße Verfahren bietet den Vorteil der kontaktlosen und damit verschleißarmen Übertragung einer Hochfrequenzleistung von einem Generator an eine Plasmaelektrodeneinheit. Damit kann die Plasmabehandlungsvorrichtung länger ohne eine Wartung betrieben werden, als dies für eine Plasmabehandlungsvorrichtung mit ohmschen Kontakten gegeben ist.

Vorzugsweise wird die Plasmaelektrodeneinheit beim Einfahren so bewegt, dass nach Erreichen der Behandlungsposition ein erster Abstand zwischen dem primären Koppelteil und dem sekundären Koppelteil vorliegt. Danach und vor dem Erzeugen des elektromagnetischen Feldes wird der primäre Koppelteil mittels einer Zustelleinheit in eine Richtung zum sekundären Koppelteil hin bewegt, bis ein zweiter Abstand des primären Koppelteils vom sekundären Koppelteil erreicht ist. Dabei ist der zweite Abstand kleiner als der erste Abstand. Nach dem Trennen des primären Koppelteils von der elektrischen Wechselleistung und vor dem Ausfahren der Plasmaelektrodeneinheit aus der Prozesskammer wird der primäre Koppelteil mittels der Zustelleinheit in eine Richtung vom sekundären Koppelteil weg bewegt, bis ein dritter Abstand des primären Koppelteils vom sekundären Koppelteil erreicht ist. Dabei ist der dritte Abstand größer als der zweite Abstand und kann vorzugsweise gleich dem ersten Abstand sein. Durch die Zustelleinheit wird damit der Abstand zwischen dem primären und dem sekundären Koppelteil so eingestellt, dass während der Schritte zum Einfahren und Ausfahren der Plasmaelektrodeneinheit in bzw. aus der Prozesskammer ein großer Abstand vorliegt, wodurch Beschädigungen an den Koppelteilen vermieden werden, und während des Schrittes zum Übertragen der Wechselleistung ein kleinerer, für die Übertragung der Wechselleistung optimaler Abstand vorliegt.

Weisen der primäre Koppelteil mindestens eine Primärspule und der sekundäre Koppelteil mindestens eine Sekundärspule auf, so ist es vorteilhaft die Primärspule während des Schrittes zum Erzeugen eines elektromagnetischen Feldes und Übertragen der Hochfrequenzleistung zu kühlen.

Nachfolgend wird die Erfindung anhand der Figuren näher erläutert. Es zeigen:
- Fig. 1: eine schematische Darstellung der erfindungsgemäßen Plasmabehandlungsvorrichtung mit einer Plasmaelektrodeneinheit und einer Übertragungsvorrichtung,
- Fig. 2: eine schematische Darstellung der erfindungsgemäßen Plasmabehandlungsvorrichtung mit mehreren Plasmaelektrodeneinheiten und mehreren Übertragungsvorrichtungen,
- Fig. 3: eine schematische Darstellung einer ersten Ausführungsform der erfindungsgemäßen Plasmabehandlungsvorrichtung mit induktiven Elementen in den Koppelteilen,
- Fig.4A: einen schematischen Querschnitt durch einen primären und einen sekundären Koppelteil, die beide Flachspulen enthalten,
- Fig. 4B: eine Draufsicht auf die Flachspulen aus Fig. 4A,
- Fig. 4C: eine schematische perspektivische Ansicht der beiden Flachspulen aus Fig. 4A,
- Fig. 5: einen schematischen Querschnitt durch einen primären und einen sekundären Koppelteil, die beide Zylinderspulen enthalten,
- Fig. 6: eine schematische Darstellung einer zweiten Ausführungsform der erfindungsgemäßen Plasmabehandlungsvorrichtung mit kapazitiven Elementen in den Koppelteilen,
- Fig. 7: einen schematischen Querschnitt durch einen primären und einen sekundären Koppelteil, bei denen die Elektroden der Koppelkondensatoren planar ausgebildet sind,
- Fig. 8: einen schematischen Querschnitt durch einen primären und einen sekundären Koppelteil, bei denen die Elektroden der Koppelkondensatoren nichtplanar ausgebildet sind,
- Fig. 9: einen schematischen Querschnitt durch einen primären und einen sekundären Koppelteil, bei denen die Elektroden der Koppelkondensatoren als Kammelektroden ausgebildet sind.

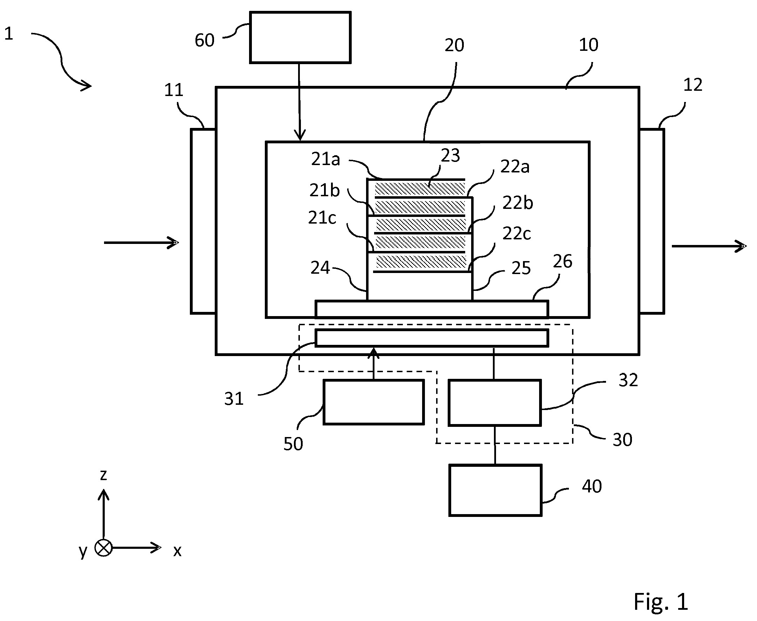

Die Figur 1 zeigt schematisch eine erfindungsgemäße Plasmabehandlungsvorrichtung 1 mit den erfindungswesentlichen Elementen. Die Plasmabehandlungsvorrichtung 1 enthält eine Prozesskammer 10, in die über eine Schleuse 11 eine Plasmaelektrodeneinheit 20 eingefahren und über eine Schleuse 12 wieder ausgefahren werden kann (dargestellt durch die Pfeile in x-Richtung). Die Plasmabehandlungsvorrichtung 1 kann jedoch auch nur eine Schleuse 11 oder 12 enthalten, durch die die Plasmaelektrodeneinheit 20 in die Prozesskammer ein- und ausgefahren wird. Darüber hinaus kann eine Schleuse auch an einer anderen Stelle der Prozesskammer, beispielsweise an ihrem oberen Ende mit Bezug auf die z-Richtung in der Zeichnung, angeordnet sein.

Die Plasmaelektrodeneinheit 20 ist in der Prozesskammer 10 vorzugsweise nur entlang der Richtung, in der sie ein- und ausgefahren wird, bewegbar, kann aber auch entlang anderer Richtungen im xyz-Koordinatensystem bewegt oder um eine Achse rotiert werden, wenn die entsprechenden Vorrichtungen zur Ausübung der Bewegung vorhanden sind. Die Plasmaelektrodeneinheit 20 umfasst im dargestellten Fall fünf Plasmaelektrodenpaare, die aus drei ersten Plasmaelektroden 21a bis 21c und drei zweiten Plasmaelektroden 22a bis 22c gebildet werden. So bilden bspw. die erste Plasmaelektrode 21a und die zweite Plasmaelektrode 22a ein erstes Plasmaelektrodenpaar, während die zweite Plasmaelektrode 22a und die erste Plasmaelektrode 21 b ein zweites Plasmaelektrodenpaar bilden. Alle ersten Plasmaelektroden 21 a bis 21 c sind über eine Zuleitung 24 elektrisch leitend miteinander verbunden und mit einer ersten elektrischen Spannung beaufschlagt. Alle zweiten Plasmaelektroden 22a bis 22c sind über eine Zuleitung 25 elektrisch leitend miteinander verbunden und mit einer zweiten elektrischen Spannung beaufschlagt. Zwischen der ersten Plasmaelektrode und der zweiten Plasmaelektrode eines Plasmaelektrodenpaares bildet sich bei Anliegen der entsprechenden Spannungen ein Plasma 23 aus, mit dem bspw. Substrate, die zwischen den Elektroden angeordnet sind (hier nicht dargestellt) behandelt werden können. Die Plasmaelektrodeneinheit 20 kann eine beliebige Anzahl von Plasmaelektrodenpaaren gleich oder größer als 1 aufweisen, wobei einzelne Plasmaelektroden spezifischer Plasmaelektrodenpaare auch mit anderen Spannungen als der ersten oder der zweiten Spannung beaufschlagt werden können. Die Plasmaelektroden der Plasmaelektrodeneinheit 20 können auch vertikal, also in z-Richtung, angeordnet sein.

Die Plasmabehandlungsvorrichtung 1 weist weiterhin eine Übertragungseinrichtung 30 auf, die eine Hochfrequenzleistung, die von einem Generator 40 bereitgestellt wird, an die Plasmaelektrodeneinheit 20 ohne einen direkten ohmschen Kontakt übertragen kann. Dazu enthält die Übertragungseinrichtung 30 einen primären Koppelteil 31, der innerhalb der Prozesskammer 10 angeordnet ist und ein elektromagnetisches Feld erzeugen kann, mit dessen Hilfe die Hochfrequenzleistung an einen sekundären Koppelteil 26, der Teil der Plasmaelektrodeneinheit 20 ist, übertragen wird. Der sekundäre Koppelteil 26 stellt dann entsprechende elektrische Spannungen und elektrische Leistungen für die einzelnen Plasmaelektroden der Plasmaelektrodenpaare zur Verfügung. Die Übertragungseinrichtung 30 enthält weiterhin eine Matchbox 32, mit der vom Generator 40 bereitgestellte Hochfrequenzleistung an die Bedingungen innerhalb der Prozesskammer 10 angepasst werden kann.

Um den Abstand zwischen dem primären Koppelteil 31 und dem sekundären Koppelteil 26 entsprechend dem jeweiligen Arbeitsschritt anpassen zu können, weist die Plasmabehandlungsvorrichtung 1 eine Zustelleinheit 50 auf, mit der der primäre Koppelteil 31 zum sekundären Koppelteil 26 hin- bzw. von diesem wegbewegt werden kann. Im dargestellten Fall entspricht dies einer Bewegung des primären Koppelteils 31 entlang der z-Richtung. Jedoch kann der primäre Koppelteil 31 alternativ auch entlang der y-Richtung bewegt werden, wenn sich der primäre Koppelteil 31 und der sekundäre Koppelteil 26 in y-Richtung gegenüber liegen. Mit anderen Worten: Die in Fig. 1 dargestellte Anordnung des primären Koppelteils 31 und des sekundären Koppelteils 26 im xyz-Koordinatensystem ist nicht zwingend vorgeschrieben, sondern ist von der Bewegungsrichtung der Plasmaelektrodeneinheit 20 in der Prozesskammer 10 und weiteren räumlichen Vorgaben der Plasmabehandlungsvorrichtung 1 abhängig. Das heißt: Der sekundäre Koppelteil 26 kann an einem unteren Ende der Plasmaelektrodeneinheit 20 (bezüglich der z-Richtung), wie in Fig. 1 dargestellt, oder an einem oberen Ende der Plasmaelektrodeneinheit 20 bezüglich der z-Richtung, an einem vorderen Ende der Plasmaelektrodeneinheit 20 bezüglich der y-Richtung oder einem hinteren Ende der Plasmaelektrodeneinheit 20 bezüglich der y-Richtung oder sogar an einem Ende der Plasmaelektrodeneinheit 20 bezüglich der x-Richtung angeordnet sein, wenn dies nicht mit dem Ein- bzw. Ausfahren der Plasmaelektrodeneinheit 20 in die bzw. aus der Prozesskammer 10 kollidiert. Entsprechend kann die Zustelleinheit 50 den primären Koppelteil 31 entlang der z-Richtung, der y-Richtung oder x-Richtung verschieben, um den Abstand zwischen dem primären Koppelteil 31 und dem sekundären Koppelteil 26 zu verändern. Für den Fall, dass die Koppelteile 31 und 26 der Übertragungseinrichtung 30 induktive Elemente zur Übertragung der Hochfrequenzleistung enthalten, wie dies später mit Bezug auf die erste Ausführungsform beschrieben wird, kann die Zustelleinheit 50 auch weggelassen werden, da die Plasmaelektrodeneinheit 20 nur über den primären Koppelteil 31, bspw. in x-Richtung, gefahren werden muss und keine weitere Bewegung des primären Koppelteils, bspw. in z- Richtung, notwendig ist.

Um den primären Koppelteil 31 und den sekundären Koppelteil 26 in der x-y-Ebene genau zueinander zu positionieren, kann die Plasmabehandlungsvorrichtung 1 weiterhin eine Justagevorrichtung 60 aufweisen, die den primären Koppelteil 31 und/oder die Plasmaelektrodeneinheit 20 und den mit ihr fest verbundenen sekundären Koppelteil 26 in x-und/oder y-Richtung verschieben kann. In Fig. 1 ist der Fall dargestellt, dass die Justagevorrichtung 60 auf die Plasmaelektrodeneinheit 20 einwirkt. Soll der primäre Koppelteil 31 in x- und/oder y-Richtung bewegt werden, so kann die Justagevorrichtung 60 auch in einer gemeinsamen Vorrichtung mit der Zustelleinheit 50 ausgeführt sein oder zumindest Teile der Zustelleinheit 50 nutzen. Besonders vorteilhafte Ausführungsformen der Plasmabehandlungsvorrichtung 1 weisen nur eine der Zustelleinheit 50 oder Justagevorrichtung 60 oder sogar keine der beiden auf.

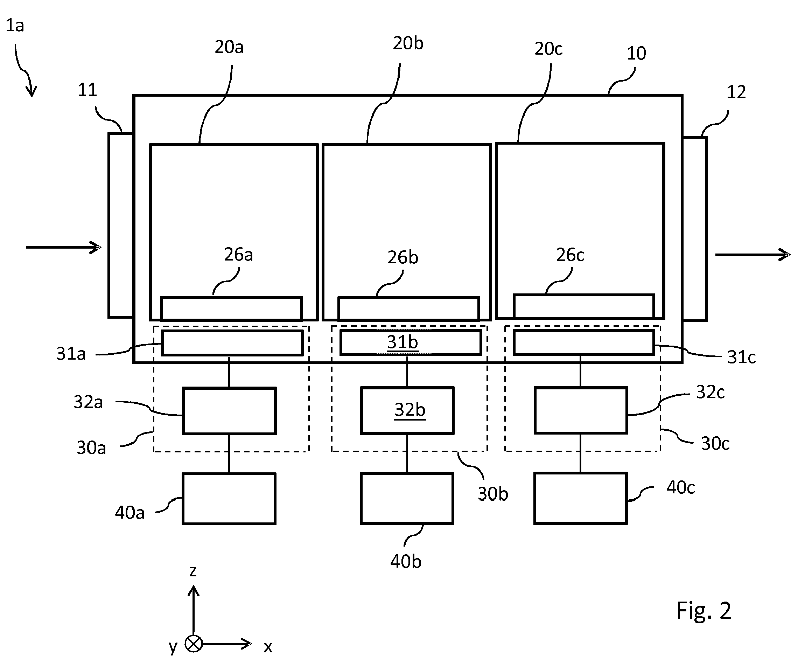

In Figur 2 ist schematisch eine Plasmabehandlungsvorrichtung 1a dargestellt, die mehrere Plasmaelektrodeneinheiten 20a bis 20c und mehrere Übertragungseinrichtungen 30a bis 30c aufweist. Dabei enthält jede Übertragungseinrichtung 30a bis 30c einen primären Koppelteil 31 a bis 31 c. Darüber hinaus kann jede Übertragungseinrichtung 30a bis 30c eine eigene Matchbox 32a bis 32c aufweisen oder sich diese auch mit anderen Übertragungseinrichtungen 30a bis 30c teilen. In der Fig. 2 ist der Fall dargestellt, dass jede Übertragungseinrichtung 30a bis 30c mit einem separaten Generator 40a bis 40c verbunden ist. Auch hier ist eine Aufteilung der Hochfrequenzleistung eines Generators auf mehrere Übertragungseinrichtungen 30a bis 30c möglich. Jede Plasmaelektrodeneinheit 20a bis 20c enthält einen sekundären Koppelteil 26a bis 26c und ist ansonsten ähnlich zu der in Fig. 1 beschriebenen Plasmaelektrodeneinheit 20 aufgebaut. Dabei können verschiedene Plasmaelektrodeneinheiten 20a bis 20c gleichartig oder verschieden voneinander, bspw. bezüglich der Anzahl oder Anordnung der Plasmaelektroden in der jeweiligen Plasmaelektrodeneinheit, ausgestaltet sein. Auf die Darstellung der Plasmaelektroden, der Zuleitungen, der Zustelleinheiten und der Justagevorrichtungen wurde im Sinne der Übersichtlichkeit der Darstellung verzichtet. In der in Fig. 2 dargestellten Ausführungsform sind alle Plasmaelektrodeneinheiten 20a bis 20c nebeneinander entlang der x-Richtung in der Plasmabehandlungsvorrichtung 1a angeordnet. Jedoch können die Plasmaelektrodeneinheiten 20a bis 20c auch nebeneinander in y-Richtung oder übereinander in z-Richtung angeordnet sein, wobei dann die primären Koppelteile 31a bis 31c sowie die Übertragungseinrichtungen 30a bis 30c gegebenenfalls auch anders angeordnet sind. Darüber hinaus können verschiedene Plasmaelektrodeneinheiten 20a bis 20c auch verschieden innerhalb der Plasmabehandlungsvorrichtung 1a angeordnet sein.

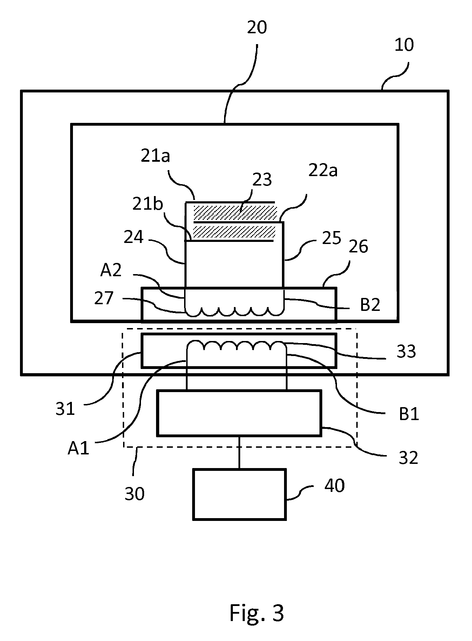

In Figur 3 ist schematisch eine erste Ausführungsform der erfindungsgemäßen Plasmabehandlungsvorrichtung, bei der die Koppelteile induktive Elemente zur Übertragung der Hochfrequenzleistung enthalten, dargestellt. Um die Übersichtlichkeit zu erhöhen, wurden nur für die Erläuterung der Wirkungsweise wichtige Komponenten der Plasmabehandlungsvorrichtung dargestellt. In der Prozesskammer 10 sind die Plasmaelektrodeneinheit 20 sowie der primäre Koppelteil 31 der Übertragungseinrichtung 30 angeordnet. Für die schematische Darstellung sind hier nur drei Plasmaelektroden 21 a, 21 b und 22a dargestellt, die zwei Plasmaelektrodenpaare bilden, zwischen denen jeweils ein Plasma 23 erzeugt wird. Der primäre Koppelteil 31 weist eine Primärspule 33 auf, deren beide Anschlüsse (Klemmen) A1 und B1 mit der Matchbox 32 verbunden sind. Der sekundäre Koppelteil 26 enthält eine Sekundärspule 27, deren einer Anschluss (Klemme) A2 über die Zuleitung 24 mit den ersten Plasmaelektroden 21 a, 21 b und deren anderer Anschluss B2 über die Zuleitung 25 mit der zweiten Plasmaelektrode 22a verbunden ist. Die Primärspule 33 erzeugt mit Hilfe der vom Generator 40 bereitgestellten Hochfrequenzleistung ein elektromagnetisches Feld, durch das in der Sekundärspule 27 eine Hochfrequenzspannung erzeugt wird. Es entsteht eine symmetrische Hochfrequenzspannung, bei der an den beiden Anschlüssen A2 und B2 jeweils um 180° phasenversetzte Wechselspannungen anliegen. Ist einer der beiden Anschlüsse A2 oder B2 in der Mitte der Sekundärspule 27 angeordnet, d.h. liegt eine Mittelanzapfung der Sekundärspule 27 vor, so sind die beiden an den Anschlüssen A2 und B2 abgegriffenen Hochfrequenzspannungen symmetrisch bezüglich Masse.

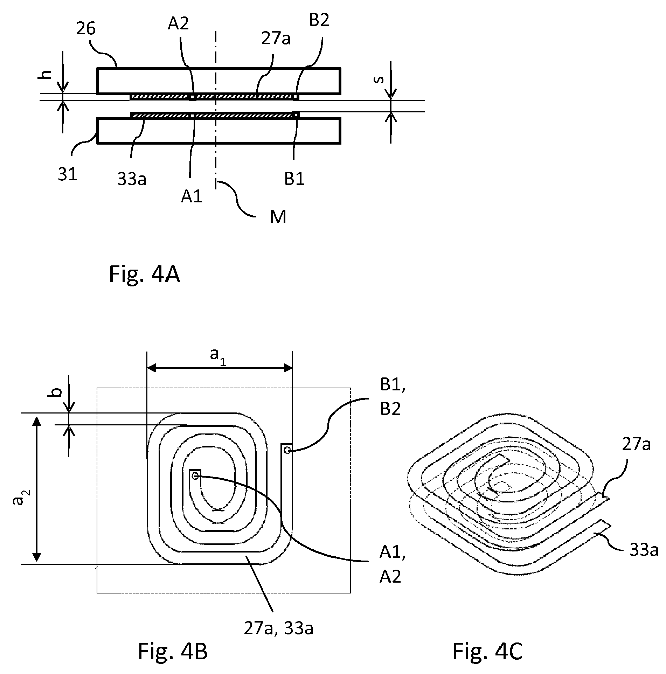

Die Figur 4A zeigt einen schematischen Querschnitt durch einen primären und einen sekundären Koppelteil 31, 26 der ersten Ausführungsform, wobei die Primärspule und die Sekundärspule als Flachspulen 33a und 27a ausgebildet sind. Bei Flachspulen liegen die beiden Anschlüsse der Spule, also die Anschlüsse A1 und B1 bzw. A2 und B2, jeweils in einer Ebene mit den Windungen der Spule. Die Flachspulen 33a und 27a können, wie in Fig. 4A dargestellt, auf einer Oberfläche des primären Koppelteils 31 bzw. des sekundären Koppelteils 26 oder in der Oberfläche (d.h. bündig mit der Oberfläche abschließend) oder im Inneren des jeweiligen Koppelteils angeordnet sein. Dabei weisen die Flachspulen 33a und 27a einen Abstand s zueinander auf, der vorteilhafterweise über die gesamte Ausdehnung der Flachspulen 33a und 27a gleich ist. Die Mittelpunkte der beiden Flachspulen 33a und 27a liegen genau senkrecht übereinander auf einer Achse, welche in Fig. 4A durch die Linie M gekennzeichnet ist. Jede Flachspule 33a, 27a hat eine Höhe h, die senkrecht zur Ebene, in der die Flachspule 33a, 27a jeweils angeordnet ist, gemessen wird. In Fig. 4A ist der Übersichtlichkeit halber nur die Höhe h der sekundären Flachspule 27a eingezeichnet. Die Höhen der beiden Flachspulen 33a und 27a können gleich oder verschieden sein.

Figur 4B zeigt schematisch eine Draufsicht auf die beiden Flachspulen 33a und 27a aus Fig. 4A. Beide Flachspulen 27a und 33a weisen eine spiralförmige Wicklung auf, bei der ein Anschluss, Anschluss A1 bzw. A2 in Fig. 4B, in der Mitte bzw. nahe des Mittelpunkts der Spule angeordnet ist, während der andere Anschluss, B1 bzw. B2, an der Außenkante der Spule angeordnet ist. Flachspulen können jedoch auch eine mäanderförmige Anordnung der Wicklungen in Rechteck- oder Quadratform haben. In Fig. 4B weisen beide Flachspulen 33a und 27a dasselbe Layout und dieselben Abmessungen in der Draufsicht auf, was auch in Fig. 4C, welche eine perspektivische Darstellung der Flachspulen 33a und 27a ist, zu sehen ist. Jedoch können die beiden Flachspulen 33a und 27a auch unterschiedliche Layouts und Abmessungen aufweisen. Als Abmessungen sind die Kantenlängen a₁ und a₂ der Spulen sowie die Breite b des Spulenmaterials in Fig. 4B eingezeichnet. Bei rechteckförmigen Flachspulen bestimmen beide Seitenabmessungen (Kantenlängen a₁ und a₂) die Induktivität der Spule.

Im Folgenden werden einige Beispiele für Materialien und Abmessungen der Flachspulen 33a und 27a sowie den Abstand s gegeben. Bspw. kann eine Flachspule aus Rohrmaterial mit einem Rohraußendurchmesser von 4 bis 12 mm ausgebildet sein, bei der die Höhe h und die Breite b dem Rohraußendurchmesser entsprechen. Ist die Flachspule aus einem Flachmaterial gebildet, so beträgt die Höhe h zwischen 0,52 und 2 mm und die Breite b zwischen 5 und 20 mm. Der Durchmesser bzw. die Kantenlängen a₁ und a₂ liegen typischerweise zwischen 50 und 250 mm und der Abstand s beträgt zwischen 3% und 10% des Durchmessers bzw. der längeren der beiden Kantenlängen, liegt also zwischen 1,5 und 25 mm.

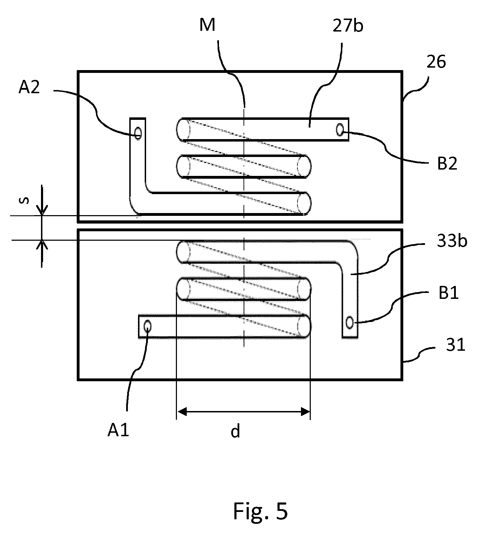

Figur 5 zeigt einen schematischen Querschnitt durch einen primären und einen sekundären Koppelteil 31, 26 der ersten Ausführungsform, wobei die Primärspule und die Sekundärspule als Zylinderspulen 33b und 27b ausgebildet sind. Bei Zylinderspulen liegen die beiden Anschlüsse der Spule, also die Anschlüsse A1 und B1 bzw. A2 und B2, jeweils nicht in einer Ebene mit den Windungen der Spule, die auf einem Zylindermantel liegen. Die Zylinderspulen 33b und 27b können, wie in Fig. 4A dargestellt, im Inneren des jeweiligen Koppelteils angeordnet sein oder an eine Oberfläche des primären Koppelteils 31 bzw. des sekundären Koppelteils 26 angrenzen. Dabei weisen die Zylinderspulen 33b und 27b einen Abstand s zueinander auf. Die beiden Zylinderspulen 33b und 27b haben die gleiche Mittelachse, welche in Fig. 5 durch die Linie M gekennzeichnet ist. Die Mittelachse kann in eine beliebige Richtung im xyz-Koordinatensystem verlaufen. Die Anschlüsse A1 und B1 bzw. A2 und B2 können, wie in Fig. 5 dargestellt, auf verschiedenen Seiten der jeweiligen Zylinderspule, aber auch auf derselben Seite der jeweiligen Zylinderspule angeordnet sein, wobei die Seite frei wählbar ist, abgesehen von der der anderen Zylinderspule zugewandten Seite. In Fig. 5 weisen beide Zylinderspulen 33b und 27b dieselbe Anschlussanordnung und dieselben Abmessungen auf. Jedoch können die beiden Zylinderspulen 33b und 27b auch unterschiedliche Anschlussanordnungen und Abmessungen sowie Windungszahlen aufweisen. Als wichtige Abmessung ist der Durchmesser d der Spulen in Fig. 5 eingezeichnet. Typischerweise werden Zylinderspulen aus einem Rohrmaterial mit einem Rohraußendurchmesser von 4 bis 12 mm ausgebildet, wobei der Durchmesser d zwischen 30 und 200 mm liegt. Der Abstand s zwischen den beiden Zylinderspulen beträgt vorteilhafterweise zwischen 50% und 100% des Durchmessers d, liegt also zwischen 15 und 200 mm.

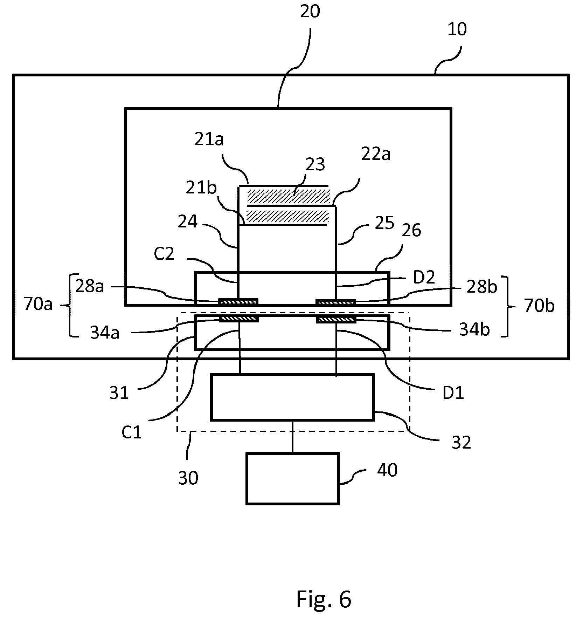

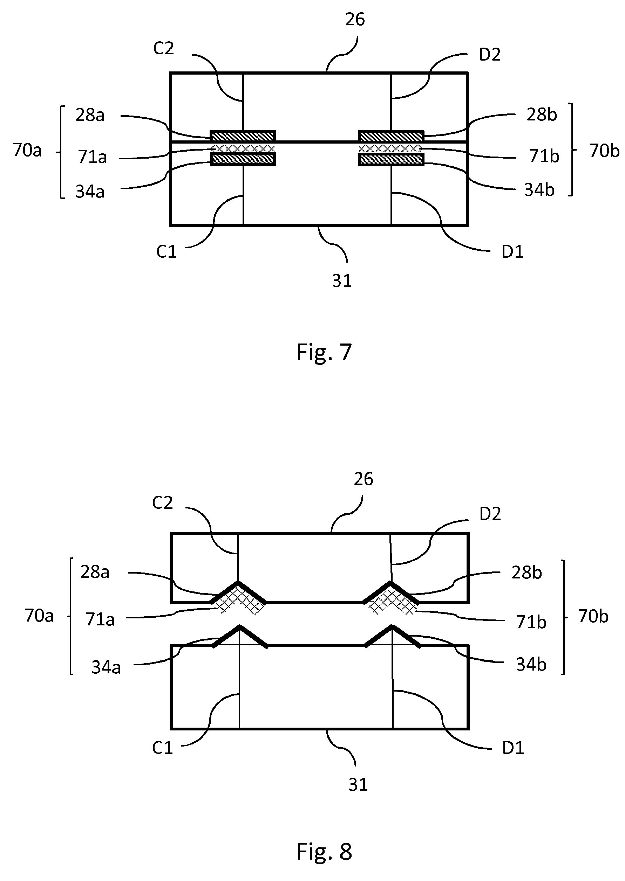

In Figur 6 ist schematisch eine zweite Ausführungsform der erfindungsgemäßen Plasmabehandlungsvorrichtung, bei der die Koppelteile kapazitive Elemente zur Übertragung der Hochfrequenzleistung enthalten, dargestellt. Um die Übersichtlichkeit zu erhöhen, wurden nur für die Erläuterung der Wirkungsweise wichtige Komponenten der Plasmabehandlungsvorrichtung dargestellt. In der Prozesskammer 10 sind die Plasmaelektrodeneinheit 20 sowie der primäre Koppelteil 31 der Übertragungseinrichtung 30 angeordnet. Für die schematische Darstellung sind hier nur drei Plasmaelektroden 21a, 21b und 22a dargestellt, die zwei Plasmaelektrodenpaare bilden, zwischen denen jeweils ein Plasma 23 erzeugt wird. Der primäre Koppelteil 31 weist eine erste Primärelektrode 34a und eine zweite Primärelektrode 34b auf, deren Anschlüsse C1 bzw. D1 mit der Matchbox 32 verbunden sind. Der sekundäre Koppelteil 26 enthält eine erste Sekundärelektrode 28a und eine zweite Sekundärelektrode 28b. Der Anschluss C2 der ersten Sekundärelektrode 28a ist über die Zuleitung 24 mit den ersten Plasmaelektroden 21 a, 21 b verbunden, während der Anschluss D2 der zweiten Sekundärelektrode 28b über die Zuleitung 25 mit der zweiten Plasmaelektrode 22a verbunden ist. Die erste Primärelektrode 34a und die erste Sekundärelektrode 28a bilden einen ersten Koppelkondensator 70a aus, während die zweite Primärelektrode 34b und die zweite Sekundärelektrode 28b in gleicher Weise einen zweiten Koppelkondensator 70b ausbilden. Über die Koppelkondensatoren 70a und 70b wird mit Hilfe eines elektromagnetischen Feldes eine, vom Hochfrequenzgenerator 40 bereitgestellte elektrische Wechselspannung an die Plasmaelektroden 21a, 21b und 22a der Plasmaelektrodeneinheit 20 übertragen. Die Primärelektroden 34a, 34b und Sekundärelektroden 28a, 28b grenzen jeweils an eine Oberfläche des Koppelteils, in dem sie enthalten sind, an, wobei diese Oberflächen der beiden Koppelteile einander gegenüber liegen. Zwischen dem primären Koppelteil 31 und dem sekundären Koppelteil 26 ist ein Spalt ausgebildet, so dass die in der Prozesskammer 10 vorliegende Atmosphäre das Dielektrikum des jeweiligen Koppelkondensators 70a, 70b bildet. Jedoch kann auch ein Dielektrikum aus einem anderen Material in den Koppelkondensatoren vorgesehen sein, wie dies mit Bezug auf die Fig. 7 und 8 nachfolgend beschrieben wird.

Figur 7 zeigt einen schematischen Querschnitt durch einen primären und einen sekundären Koppelteil 31, 26 der zweiten Ausführungsform, wobei die Primärelektroden 34a, 34b und die Sekundärelektroden 28a, 28b als planare, d.h. ebene, Elektroden ausgebildet sind. In Fig. 7 ist eine Position, in der die Übertragung der elektrischen Wechselleistung realisiert wird, dargestellt. Vor einem Schritt zum Ein- oder Ausfahren der Plasmaelektrodeneinheit in die bzw. aus der Prozesskammer werden der primäre Koppelteil 31 und der sekundäre Koppelteil 26 voneinander weg bewegt, so dass die Elemente eines spezifischen Koppelkondensators, die zu verschiedenen Koppelteilen gehören, nicht mehr aneinander grenzen, um einen mechanischen Verschleiß der Elemente der Koppelkondensatoren 70a, 70b zu verringern. Zwischen der ersten Primärelektrode 34a und der ersten Sekundärelektrode 28a ist ein erstes Dielektrikum 71 a angeordnet, welches einen integralen Bestandteil des ersten Koppelkondensators 70a bildet. In gleicher Weise ist zwischen der zweiten Primärelektrode 34b und der zweiten Sekundärelektrode 28b ist ein zweites Dielektrikum 71 b angeordnet, welches einen integralen Bestandteil des zweiten Koppelkondensators 70b bildet. Das Dielektrikum 71 a, 71 b kann auf der jeweiligen Primärelektrode 34a, 34b oder auf der jeweiligen Sekundärelektrode 28a, 28b angeordnet und fest mit dieser verbunden sein. Es ist jedoch auch möglich, dass das Dielektrikum 71 a, 71 b aus zwei getrennten dielektrischen Schichten, von denen jeweils eine auf der Primärelektrode 34a, 34b und eine andere auf der Sekundärelektrode 28a, 28b angeordnet ist, gebildet wird. Der primäre Koppelteil 31 und der sekundäre Koppelteil 26 grenzen aneinander an. Dabei kann die Elektrode, auf der das Dielektrikum angeordnet ist, an die Oberfläche des jeweiligen Koppelteils angrenzen oder eben auch nicht. Ein Fall, in dem die Oberfläche des Dielektrikums 71 a, 71 b, welche nicht mit einer der Elektroden fest verbunden ist, mit der Oberfläche des Koppelteils abschließt, d.h. auf einer Ebene liegt, ist in Fig. 7 dargestellt.

Die Elemente der beiden Koppelkondensatoren 70a, 70b, d.h. die Primärelektroden 34a und 34b, die Sekundärelektroden 28a und 28b sowie die Dielektrika 71a und 71b, können gleich oder zumindest teilweise verschieden bezüglich ihrer Abmessungen (Länge, Breite, Dicke) und des Materials ausgebildet sein. Die Abmessungen und Materialien werden dabei von der zu erreichenden Kapazität der Koppelkondensatoren 70a, 70b und den in der Plasmabehandlungsvorrichtung vorliegenden Abmessungen und Bedingungen (Temperatur, Druck, Gaszusammensetzung) bestimmt.

Figur 8 zeigt einen schematischen Querschnitt durch einen primären und einen sekundären Koppelteil 31, 26 der zweiten Ausführungsform, wobei die Primärelektroden 34a, 34b und die Sekundärelektroden 28a, 28b als nichtplanare Elektroden ausgebildet sind. In Fig. 8 ist diesmal eine Position dargestellt, in der die Koppelkondensatoren 70a, 70b aufgetrennt sind, so dass die Plasmaelektrodeneinheit ein- oder ausgefahren werden kann. Die Elektroden 28a, 28b, 34a und 34b weisen eine sägezahnförmige oder dachförmige Kontur im Querschnitt auf, wobei einzelne Bereiche einer spezifischen Elektrode 28a, 28b, 34a oder 34b planare Abschnitte enthalten. Jedoch können auch alle Bereiche einer spezifischen Elektrode 28a, 28b, 34a oder 34b gebogen sein. Die Sekundärelektroden 28a und 28b sind im dargestellten Fall als Vertiefungen in der Oberfläche des sekundären Koppelteils 26 geformt, während die Primärelektroden 34a und 34b als Erhebungen auf der Oberfläche des primären Koppelteils 31 ausgebildet sind. Im vorliegenden Fall sind die Dielektrika 71 a, 71 b auf der jeweiligen Sekundärelektrode 28a bzw. 28b angeordnet und weisen dieselbe Kontur wie die Elektroden 28a, 28b, 34a und 34b auf. Die Elektroden 28a, 28b, 34a und 34b und die Dielektrika 71 a, 71 b sind dabei so geformt, dass sie beim Schließen der Koppelkondensatoren 70a, 70b ohne einen parasitären Spalt ineinandergreifen. Vorteilhafterweise sind sie darüber hinaus so geformt, dass sie beim Schließen der Koppelkondensatoren 70a, 70b zu einer Selbstjustage der Primärelektroden 34a, 34b zu den jeweiligen Sekundärelektroden 28a, 28b führen.

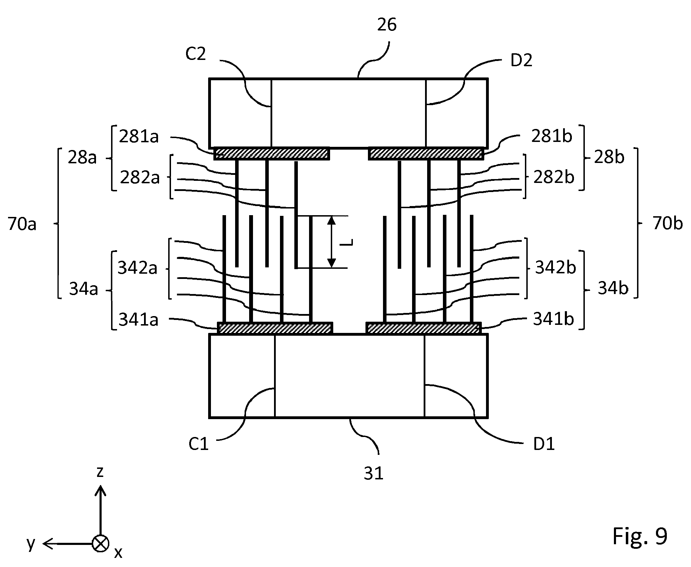

Figur 9 zeigt einen schematischen Querschnitt durch einen primären und einen sekundären Koppelteil 31, 26 der zweiten Ausführungsform, bei der die Elektroden 28a, 28b, 34a und 34b der Koppelkondensatoren 70a, 70b als Kammelektroden ausgebildet sind. Um die Übersichtlichkeit der Darstellung zu erhöhen, wurde der sekundäre Koppelteil 26 weiter in positive z-Richtung verschoben dargestellt, als dies im Realfall gegeben ist. Die Elektroden 28a, 28b, 34a und 34b bestehen jeweils aus einem Anschlussbereich 281 a, 281 b, 341 a bzw. 341 b sowie einem oder mehreren plattenförmigen Bereichen 282a, 282b, 342a bzw. 342b. Die plattenförmigen Bereiche 282a, 282b, 342a bzw. 342b erstrecken sich dabei von dem jeweiligen Anschlussbereich 281 a, 281 b, 341 a bzw. 341 b aus in z-Richtung und in x-Richtung und sind in y-Richtung voneinander beabstandet. Die Richtungen des xyz-Koordinatensystems entsprechen dabei den Richtungen, wie sie mit Bezug auf Fig. 1 bzw. 2 dargestellt sind. Das heißt: Die Ansicht von Fig. 9 ist eine Ansicht der beiden Koppelteile 26 und 31 in Bewegungsrichtung der Plasmaelektrodeneinheit. Die plattenförmigen Bereiche 282a, 282b, 342a bzw. 342b sind daher so ausgebildet, dass die Plasmaelektrodeneinheit mit den im sekundären Koppelteil 26 enthaltenen plattenförmigen Bereichen 282a und 282b in die Zwischenräume zwischen den plattenförmigen Bereichen 342a bzw. 342b des ortsfesten primären Koppelteils 31 ein- bzw. daraus ausfahren kann, ohne dass es zu Berührungen zwischen den plattenförmigen Bereichen 282a, 282b, 342a bzw. 342b der beiden Koppelteile 26, 31 kommt. Dabei liegen bei eingefahrener Plasmaelektrodeneinheit zwischen den plattenförmigen Bereichen 282a und 342a bzw. 282b und 342b jeweils gleiche Abstände im Bereich von 0,1 bis 10 mm, gemessen in y-Richtung, vor. Die plattenförmigen Bereiche überlappen sich dabei in z-Richtung über einen Bereich mit einer Überlappungshöhe L, der, wie bereits erwähnt, im Realfall größer als in der Darstellung der Fig. 9 ist und vorzugsweise der Länge der plattenförmigen Bereiche 282a, 282b, 342a bzw. 342b in z-Richtung minus einen Betrag zwischen 0,1 und 10 mm entspricht. Die in den Koppelkondensatoren 70a, 70b erreichte Kapazität wird durch die Überlappungshöhe L in z-Richtung sowie eine Überlappungslänge in x-Richtung und den Abstand zwischen den einzelnen plattenförmigen Bereichen 282a und 342a bzw. 282b und 342b in y-Richtung bestimmt. Vorteilhaft an dieser Ausgestaltung ist, dass die Anforderungen an eine Positioniergenauigkeit der Plasmaelektrodeneinheit in x-Richtung relativ gering sind. Bspw. ist bei einer Länge der plattenförmigen Bereiche 282a, 282b, 342a bzw. 342b in x-Richtung von 180 mm eine Positioniergenauigkeit der plattenförmigen Bereiche 282a, 282b, 342a bzw. 342b in x-Richtung von ± 5 mm ausreichend. Darüber hinaus sind sogar Durchlaufanlagen realisierbar, bei denen die Plasmaelektrodeneinheit kontinuierlich auch während des Behandlungsprozesses bewegt wird, wobei sich die plattenförmigen Bereiche 342a und 342b der Primärelektroden 34a, 34b dabei über die gesamte Länge der Prozesskammer in x-Richtung erstrecken (mit Ausnahme von Randbereichen, die für eine Isolierung der Primärelektroden 34a, 34b von den Wänden der Prozesskammer notwendig sind).

Die genaue Ausgestaltung des primären Koppelteils und des sekundären Koppelteils in allen Ausführungsformen kann optimal an die Bedingungen in der Prozesskammer und an diefür die Erzeugung und Aufrechterhaltung des Plasmas zwischen den Plasmaelektroden eines Plasmaelektrodenpaares notwendigen elektrischen Leistungen angepasst werden. Dabei können ggf. auch verschiedene Ausführungsformen und Ausgestaltungen miteinander kombiniert werden.

### Bezugszeichen

- 1, 1a: Plasmabehandlungsvorrichtung
- 10: Prozesskammer
- 11, 12: Schleuse
- 20, 20a-c: Plasmaelektrodeneinheit
- 21a-c: Erste Plasmaelektrode eines Plasmaelektrodenpaares
- 22a-c: Zweite Plasmaelektrode eines Plasmaelektrodenpaares
- 23: Plasma
- 24, 25: Zuleitung
- 26, 26a-c: Sekundärer Koppelteil
- 27: Sekundärspule
- 27a: Sekundärspule als Flachspule
- 27b: Sekundärspule als Zylinderspule
- 28a: Erste Sekundärelektrode
- 28b: Zweite Sekundärelektrode
- 281a, b: Anschlussbereich einer Sekundärelektrode
- 282a, b: Plattenförmiger Bereich einer Sekundärelektrode
- 30, 30a-c: Übertragungseinrichtung
- 31, 31a-c: Primärer Koppelteil
- 32, 32a-c: Matchbox
- 33: Primärspule
- 33a: Primärspule als Flachspule
- 33b: Primärspule als Zylinderspule
- 34a: Erste Primärelektrode
- 34b: Zweite Primärelektrode
- 341a, b: Anschlussbereich einer Primärelektrode
- 342a, b: Plattenförmiger Bereich einer Primärelektrode
- 40, 40a-c: Generator
- 50: Zustelleinheit
- 60: Justagevorrichtung
- 70a: Erster Koppelkondensator
- 70b: Zweiter Koppelkondensator
- 71a: Erstes Dielektrikum
- 71b: Zweites Dielektrikum

- A1, B1: Anschlüsse der Primärspule
- A2, B2: Anschlüsse der Sekundärspule
- C1, D1: Anschlüsse der Primärelektroden
- C2, D2: Anschlüsse der Sekundärelektroden
- a₁, a₂: Kantenlänge der Primär- und Sekundärspule
- b: Breite der Primär- und Sekundärspule
- d: Durchmesser der Primär- und Sekundärspule
- h: Höhe der Flachspule
- s: Abstand zwischen den induktiven oder kapazitiven Elementen des primären Koppelteils und des sekundären Koppelteils
- L: Überlappungshöhe der plattenförmigen Bereiche

## Patentansprüche

1. Plasmabehandlungsvorrichtung mit
- einer Prozesskammer,
- einer Plasmaelektrodeneinheit, die aus mindestens einem Plasmaelektrodenpaar aus zwei parallelen, einander gegenüber liegenden und elektrisch voneinander isolierten Plasmaelektroden besteht und die geeignet ist, in die Prozesskammer ein- und aus ihr ausgefahren zu werden, und
- einer, zumindest teilweise in der Prozesskammer angeordneten Übertragungseinrichtung, die zur Übertragung einer, für die Erzeugung und Aufrechterhaltung eines Plasmas zwischen den Plasmaelektroden eines Plasmaelektrodenpaares der Plasmaelektrodeneinheit notwendigen elektrischen Leistung von einem Generator, der außerhalb der Prozesskammer angeordnet ist, an die Plasmaelektrodeneinheit geeignet ist, wenn sich die Plasmaelektrodeneinheit in der Prozesskammer in einer Behandlungsposition befindet,
**dadurch gekennzeichnet, dass**
- die Übertragungseinrichtung einen primären Koppelteil enthält, der innerhalb der Prozesskammer angeordnet ist,
- die Plasmaelektrodeneinheit einen sekundären Koppelteil enthält, der fest mit der Plasmaelektrodeneinheit verbunden ist, und
- der primäre Koppelteil und der sekundäre Koppelteil so angeordnet sind, dass sie geeignet sind, eine vom Generator bereitgestellte elektrische Hochfrequenzleistung mit Hilfe eines oder mehrerer elektromagnetischen Felder und ohne einen ohmschen elektrischen Kontakt an die Plasmaelektrodeneinheit zu übertragen.

2. Plasmabehandlungsvorrichtung nach Anspruch 1, **dadurch gekennzeichnet, dass** die übertragene elektrische Hochfrequenzleistung eine Frequenz im Bereich von 10 kHz bis 100 MHz aufweist.

3. Plasmabehandlungsvorrichtung nach Anspruch 1 oder 2, **dadurch gekennzeichnet, dass**
- die Plasmaelektroden der Plasmaelektrodeneinheit so ausgebildet sind, dass sie gegen Massepotential isoliert in der Plasmabehandlungsvorrichtung angeordnet sind, wenn sich die Plasmaelektrodeneinheit in einer Behandlungsposition befindet, und
- der primäre Koppelteil und der sekundäre Koppelteil geeignet sind, die Hochfrequenzleistung einander zugeordneten Plasmaelektroden der Plasmaelektrodeneinheit, symmetrisch bezüglich Massepotential zuzuführen.

4. Plasmabehandlungsvorrichtung nach einem der Ansprüche 1 bis 3, **dadurch gekennzeichnet, dass** die Plasmabehandlungsvorrichtung weiterhin eine Zustelleinheit umfasst, die geeignet ist, den primären Koppelteil in eine Richtung zum sekundären Koppelteil hin oder von diesem weg zu bewegen, wenn sich die Plasmaelektrodeneinheit in der Prozesskammer in einer Behandlungsposition befindet.

5. Plasmabehandlungsvorrichtung nach einem der Ansprüche 1 bis 4, **dadurch gekennzeichnet, dass** der primäre Koppelteil mindestens eine Primärspule und der sekundäre Koppelteil mindestens eine Sekundärspule aufweisen, wobei jede Sekundärspule einer Primärspule zugeordnet ist und wobei jeweils ein Ende der Sekundärspule mit einer Plasmaelektrode eines Plasmaelektrodenpaares und ein anderes Ende der Sekundärspule mit der anderen Plasmaelektrode desselben Plasmaelektrodenpaares elektrisch leitend verbunden ist, wobei die mindestens eine Primärspule geeignet ist, mit Hilfe der vom Generator bereitgestellten Hochfrequenzleistung ein elektromagnetisches Feld zu erzeugen und die mindestens eine Sekundärspule geeignet ist, das von der mindestens einen Primärspule erzeugte elektromagnetische Feld aufzunehmen.

6. Plasmabehandlungsvorrichtung nach Anspruch 5, **dadurch gekennzeichnet, dass** mindestens eine der mindestens einen Primärspule und die dieser Primärspule zugeordnete mindestens eine Sekundärspule als Flachspulen ausgebildet sind.

7. Plasmabehandlungsvorrichtung nach Anspruch 5, **dadurch gekennzeichnet, dass** mindestens eine der mindestens einen Primärspule und die dieser Primärspule zugeordnete mindestens eine Sekundärspule als Zylinderspulen ausgebildet sind.

8. Plasmabehandlungsvorrichtung nach einem der Ansprüche 5 bis 7, **dadurch gekennzeichnet, dass** mindestens die Sekundärspule aus einem Material besteht, dass unter Vakuumbedingungen eine Temperaturbeständigkeit bis mindestens 450°C und eine elektrische Leitfähigkeit von mindestens 10⁺⁷ S/m aufweist.

9. Plasmabehandlungsvorrichtung nach einem der Ansprüche 1 bis 4, **dadurch gekennzeichnet, dass** der primäre Koppelteil mindestens zwei Primärelektroden und der sekundäre Koppelteil mindestens zwei Sekundärelektroden aufweisen, wobei jede Sekundärelektrode einer spezifischen Primärelektrode zugeordnet und geeignet ist, mit dieser einen Kondensator auszubilden, und wobei die Primärelektrode eines ersten Kondensators mit einem Anschluss des Generators und die Primärelektrode eines zweiten Kondensators mit dem anderen Anschluss des Generators elektrisch leitend verbunden sind und die Sekundärelektrode des ersten Kondensators mit einer Plasmaelektrode eines Plasmaelektrodenpaares und die Sekundärelektrode des zweiten Kondensators mit der anderen Plasmaelektrode desselben Plasmaelektrodenpaares elektrisch leitend verbunden sind.

10. Plasmabehandlungsvorrichtung nach Anspruch 4 und 9, **dadurch gekennzeichnet, dass** mindestens eine der Primärelektrode oder der Sekundärelektrode eines spezifischen Kondensators ein Dielektrikum aufweist, das mit der jeweils zugeordneten Sekundärelektrode oder Primärelektrode des spezifischen Kondensators in mechanischem Kontakt steht, wenn sich die Plasmaelektrodeneinheit in der Prozesskammer in einer Behandlungsposition befindet und die Zustelleinheit den primären Koppelteil in Richtung des sekundären Koppelteils bewegt hat.

11. Plasmabehandlungsvorrichtung nach Anspruch 9 oder 10, **dadurch gekennzeichnet, dass** die Primärelektrode und die Sekundärelektrode mindestens eines spezifischen Kondensators jeweils eine nichtplanare Oberfläche aufweisen, die der jeweils anderen Elektrode gegenüberliegt und mit der Form der nichtplanaren Oberfläche der jeweils anderen Elektrode korrespondiert.

12. Plasmabehandlungsvorrichtung nach Anspruch 9, **dadurch gekennzeichnet, dass** die Primärelektrode und die Sekundärelektrode mindestens eines spezifischen Kondensators jeweils mindestens zwei plattenförmige Bereiche aufweisen, die sich von einem gemeinsamen Anschlussbereich aus jeweils in Richtung der jeweils anderen Elektrode sowie in eine Richtung erstrecken, entlang der die Plasmaelektrodeneinheit in die Prozesskammer ein- und aus ihr ausgefahren wird, wobei die plattenförmigen Bereiche der Primärelektrode und der Sekundärelektrode zumindest teilweise einander gegenüber angeordnet sind, wenn sich die Plasmaelektrodeneinheit in der Prozesskammer in einer Behandlungsposition befindet.

13. Plasmabehandlungsvorrichtung nach einem der Ansprüche 1 bis 12, **dadurch gekennzeichnet, dass** die Plasmabehandlungsvorrichtung mehrere Plasmaelektrodeneinheiten und mehrere Übertragungseinrichtungen enthält, wobei jede Plasmaelektrodeneinheit einer spezifischen Übertragungseinrichtung zugeordnet ist und jede Übertragungseinrichtung einen primären Koppelteil und jede Plasmaelektrodeneinheit einen sekundären Koppelteil aufweisen, die zur Übertragung von Hochfrequenzleistung an die jeweilige Plasmaelektrodeneinheit mittels elektromagnetischer Felder und ohne ohmschen elektrischen Kontakt zueinander geeignet sind.

14. Verfahren zum Betreiben einer Plasmabehandlungsvorrichtung nach einem der Ansprüche 1 bis 13, mit den Schritten:
- Einfahren der Plasmaelektrodeneinheit in die Prozesskammer entlang einer ersten Richtung, bis sich die Plasmaelektrodeneinheit in einer Behandlungsposition in der Prozesskammer befindet und sich der primäre Koppelteil und der sekundäre Koppelteil zumindest teilweise gegenüber liegen,
- Erzeugen eines elektromagnetischen Feldes im primären Koppelteil durch Anlegen einer von einem Generator bereitgestellten Hochfrequenzleistung und Übertragen der Hochfrequenzleistung an den sekundären Koppelteil nach Beendigung des Schrittes zum Einfahren der Plasmaelektrodeneinheit, wodurch ein Plasma zwischen den Plasmaelektroden eines Plasmaelektrodenpaares der Plasmaelektrodeneinheit erzeugt und aufrechterhalten wird,
- Trennen des primären Koppelteils von der von dem Generator bereitgestellten Hochfrequenzleistung nach Erreichen eines Bearbeitungszieles in der Prozesskammer,
- Ausfahren der Plasmaelektrodeneinheit aus der Prozesskammer entlang der ersten Richtung nach dem Trennen des primären Koppelteils von der von dem Generator bereitgestellten Hochfrequenzleistung.

15. Verfahren nach Anspruch 14, **dadurch gekennzeichnet, dass**
- die Plasmaelektrodeneinheit beim Einfahren so bewegt wird, dass nach Erreichen der Behandlungsposition ein erster Abstand zwischen dem primären Koppelteil und dem sekundären Koppelteil vorliegt,
- nach dem Einfahren der Plasmaelektrodeneinheit in die Prozesskammer und vor dem Erzeugen des elektromagnetischen Feldes der primäre Koppelteil mittels einer Zustelleinheit in eine Richtung zum sekundären Koppelteil hin bewegt wird, bis ein zweiter Abstand des primären Koppelteils vom sekundären Koppelteil erreicht ist, wobei der zweite Abstand kleiner als der erste Abstand ist, und
- nach dem Trennen des primären Koppelteils von der Hochfrequenzleistung und vor dem Ausfahren der Plasmaelektrodeneinheit aus der Prozesskammer der primäre Koppelteil mittels der Zustelleinheit in eine Richtung vom sekundären Koppelteil weg bewegt wird, bis ein dritter Abstand des primären Koppelteils vom sekundären Koppelteil erreicht ist, wobei der dritte Abstand größer als der zweite Abstand ist.

16. Verfahren nach einem der Ansprüche 14 oder 15, **dadurch gekennzeichnet, dass**
- der primäre Koppelteil mindestens eine Primärspule und der sekundäre Koppelteil mindestens eine Sekundärspule aufweisen und
- mindestens die Primärspule während des Schrittes zum Erzeugen eines elektromagnetischen Feldes gekühlt wird.
